# EUROPÄISCHE PATENTSCHRIFT

(11) **EP 3 204 739 B1**
(45) Veröffentlichungstag und Bekanntmachung des Hinweises auf die Patenterteilung: **18.01.2023**
(21) Anmeldenummer: 15797834.7
(22) Anmeldetag: 07.10.2015
(51) Int. Cl.: G01J 3/26, G01J 3/36, G01J 3/02, G01J 3/12, H01L 27/30

(54) **VORRICHTUNG ZUR SPEKTROMETRISCHEN ERFASSUNG VON LICHT MIT EINER PHOTODIODE, DIE MONOLITHISCH IN DIE SCHICHTSTRUKTUR EINES WELLENLÄNGENSELEKTIVEN FILTERS INTEGRIERT IST**
APPARATUS FOR SPECTROMETRICALLY CAPTURING LIGHT WITH A PHOTODIODE WHICH IS MONOLITHICALLY INTEGRATED IN THE LAYER STRUCTURE OF A WAVELENGTH-SELECTIVE FILTER
DISPOSITIF DE DÉTECTION SPECTROMÉTRIQUE DE LA LUMIÈRE COMPRENANT UNE PHOTODIODE QUI EST INTÉGRÉE DE MANIÈRE MONOLITHIQUE DANS LA STRUCTURE DE COUCHE D'UN FILTRE À LONGUEUR D'ONDE SELECTIVE

(30) Priorität: 07.10.2014 DE 102014014981
(43) Veröffentlichungstag der Anmeldung: 16.08.2017
(73) Patentinhaber: SENORICS GmbH, 01217 Dresden (DE)
(72) Erfinder: LANGNER, Maik, 01159 Dresden (DE); FRÖB, Hartmut, 01768 Glashütte (DE); LYSSENKO, Vadim, G., 01069 Dresden (DE); SUDZIUS, Markas, 01069 Dresden (DE); LEO, Karl, 01219 Dresden (DE)
(74) Vertreter: Kailuweit & Uhlemann Patentanwälte Partnerschaft mbB
(86) Internationale Anmeldenummer: PCT/DE2015/000503
(87) Internationale Veröffentlichungsnummer: WO 2016/055047

(56) Entgegenhaltungen:
- US-A- 5 455 421
- US-A1- 2002 017 612
- US-B1- 6 380 531

## Beschreibung

Die Erfindung betrifft eine Vorrichtung zur spektrometrischen Erfassung von Licht gemäss Anspruch 1.

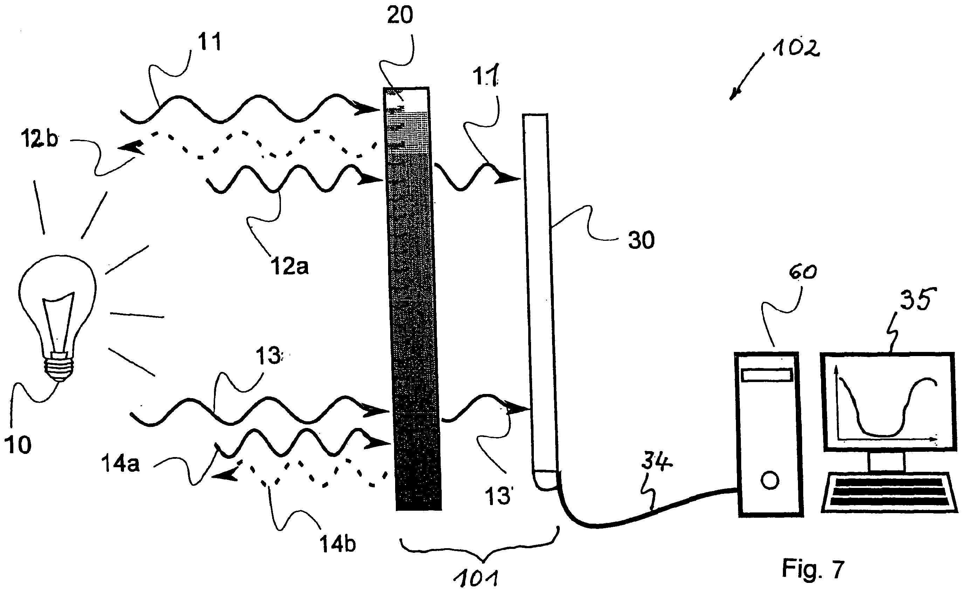

Eine in Fig. 7 dargestellte, herkömmliche spektral auflösende Vorrichtung 101 innerhalb einer spektrometrischen Einrichtung 102 besteht aus mindestens einem Filter 20, der die spektrale Information in eine Ortsinformation umwandelt, sowie einem Detektor 30, der die erfasste Ortsinformation in Form des anschließend in einem begrenzten Wellenlängenbereich zuzuordnenden Signals in einen Datenstrom umwandelt. Die zwei Komponenten - Filter 20 und Detektor 30 - werden einzeln hergestellt und müssen anschließend justiert und fixiert werden. Dadurch ist eine Massenfertigung infolge zumindest hoher Kosten schwierig umzusetzen, und die mechanische Stabilität sowie die gegebenenfalls notwendige geometrische Ausdehnung können Einsatzorte und Einsatzzwecke verhindern.

In der Druckschrift US 2014/0 106 468 A1 sind ein photonischer Kristallsensor und ein Verfahren zur Erfassung eines Analytikums beschrieben.

Der Sensor besteht aus einem photonischen Kristall, wobei der photonische Kristall aus einem Analytikum-sensitiven polymerischen Material gebildet ist, wobei das Material bei einem Kontakt mit dem Analytikum deformierbar ist, wobei durch den Kontakt eine optische Eigenschaft des photonischen Kristalls verändert wird oder von dessen Material ein Brechungsindex durch den Kontakt mit dem genannten Analytikum-sensitiven Material verändert wird und das Analytikum-sensitive Material einen Teil einer periodischen Struktur des photonischen Kristalls bildet, wobei die Struktur wechselnde Zonen eines relativ hohen Brechungsindexes und Zonen eines relativ niedrigen Brechungsindexes hat, wobei die wechselnden Zonen in einer oder zwei orthogonalen Richtungen des Analytikum-sensitiven Materials vorgesehen sind.

Das zugehörige Verfahren zur Herstellung eines solchen optischen Sensors, der den photonischen Kristall zur Erfassung eines Analytikums aufweist, umfasst folgende Schritte:
Erzeugen eines Stempels mit einer Oberfläche, die ein Muster zum Aufdrucken einer periodischen Struktur für den photonischen Kristall enthält,
Erzeugen eines druckfähigen Analytikum-sensitiven Materials für den photonischen Kristall,
Aufdrucken der periodischen Struktur in das druckfähige Material durch Pressen der genannten Oberfläche des Stempels in eine Oberfläche des druckfähigen Materials,
wahlweise Härten des Materials, in das die periodische Struktur gedruckt worden ist, und
wobei das Aufdrucken und das wahlweise Härten des photonischen Kristalls durchgeführt werden,
wobei das Material des photonischen Kristalls, in den die periodische Struktur eingedruckt worden ist, deformierbar ist, wenn mit dem Analytikum kontaktiert wird,
wobei die Deformation des Materials eine optische Eigenschaft des photonischen Kristalls verändert oder
wobei der Brechungsindex des Materials des photonischen Kristalls, in dem die periodische Struktur eingedruckt worden ist, durch den Kontakt mit dem genannten Analytikum veränderlich ist.

Der Nachteil besteht darin, dass dieser Sensor für ein spezifisches Analytikum konzipiert ist, das dazu mit dem Sensor wechselwirken muss. Gemessen wird anschließend z. B.: die spektrale Verschiebung einer Resonanz oder eine Intensitätsänderung. Nachteilig ist es, dass für diesen Prozess eine gewisse Zeit t (einige s bis wenige min) bis zur Einstellung eines Gleichgewichtszustandes notwendig ist, sowohl bei der Erfassung des Analytikums als auch bei der anschließenden Reaktivierung des Sensors. Zusätzlich ist es nicht ersichtlich, in welcher Form ein breites Lichtspektrum durch den Sensor analysiert wird.

In der Druckschrift US 2012/0 136 227 A1 ist ein spektrophotometrischer Sensor beschrieben, der aus folgenden Elementen:
einem Sensorkörper,
einem lichtemittierenden Element, das an dem Sensorkörper anliegt,
einem Wellenlängen unterscheidenden Detektor, der an dem Sensorkörper angeordnet ist, wobei der Wellenlängen unterscheidende Detektor aus einer organisches Licht emittierenden Diode oder einem organischen Photodetektor besteht.

Der Wellenlängen unterscheidende Detektor erfasst Licht einer oder mehrerer diskreter Wellenlängen.

Die organisches Licht emittierende Diode oder der organische Photodetektor können bestehen aus:
einer organischen Schicht,
einer Substratschicht und
einer oder mehreren transparenten Elektrodenschichten.

Der Nachteil besteht darin, dass bei dem beschriebenen Sensor nur eine grobe Auflösung eines Spektrums möglich ist, d.h. es können spektrale Bänder von 50 - 100 nm Breite voneinander getrennt erfasst werden, da ausschließlich über die Absorptionseigenschaften der OLEDs bzw. Photodetektoren eine Detektion/Separation stattfindet. Des Weiteren ist bei der vorgeschlagenen Verwendung von OLEDs im Rückwärtsbetrieb mit einer schlechten Effizienz der Signalerfassung zu rechnen.

In der Druckschrift US 2009/0 220 189 A1 ist ein Detektorsystem zur Erfassung von transmittierendem Licht mit lateralen Veränderungen beschrieben.

Das Detektorsystem umfasst einen optischen Sensor, der ein oder mehrere Teil-Bande von optischen Wellenlängen ausgibt, wenn dieser mit einem breiten Band von optischen Wellenlängen beleuchtet werden, und einen Detektor, der umfasst mindestens eine Schicht mit lateral veränderlichen Transmissionseigenschaften, wobei der Detektor Austrittslicht durch den optischen Sensor empfängt und einen Teil des empfangenen Lichts auf einer Position von mindestens einer Schicht durchlässt, wobei der Detektor die Position nutzt, um Wellenlängenänderungen beim Austritt aus dem optischen Sensor zu bestimmen.

Ein Nachteil besteht darin, dass das Detektorsystem einen zusätzlichen optischen Sensor zur Vorselektion des Breitbandspektrums und anschließenden Einkopplung in den Detektor benötigt. Des Weiteren ist aus der Beschreibung keine vollständige monolithische Verbindung zwischen spektralem Filterelement und den optischen Ausleseeinheiten ersichtlich, was eine Ausrichtung der Komponenten zueinander erforderlich macht. Ein weiterer Nachteil ist die Verwendung von herkömmlichen Photosensoren aus anorganischem HalbleiterMaterial, deren Herstellung aufwändig und kostenintensiv ist. Eine Kombination oder gar eine Integration der Sensoren in/mit photonische/n Kristalle/n ist auf Grund der unterschiedlichen Materialien/Verfahren zur Herstellung der Filmstrukturen der photonischen Kristalle schwierig bis unmöglich.

In den folgenden Druckschriften sind Photodetektoren beschrieben, die mit optischen Kavitäten gekoppelt sind.

Dabei zeigt die US 5,455,421 A einen Photodetektor mit einer aktiven Schicht zwischen zwei Elektroden, der zwischen einem metallischen Reflektor und einer dielektrischen Schicht angeordnet ist.

In der Druckschrift US 6,380,531 B1 ist ein Photodetektor gezeigt, der innerhalb eines Fabry-Perot-Etalons angeordnet ist.

Die Druckschrift US 2002/0 017 612 A1 behandelt organische Photodetektoren mit mittels einer Vorspannung schaltbarer Empfindlichkeit. Die Photodetektoren können als Mikrokavitäten in der Konfiguration Metall/organische photoaktive Schicht/Metall ausgebildet sein, wobei die Mikrokavitäten eine selektive spektrale Antwort aufweisen. Die Druckschrift beschreibt auch wellenlängenselektive Detektoren mit Mikrokavitäten auf einem Substrat, das zusätzlich einen Schichtstapel aufweist. Es wird vorgeschlagen, ein Array oder eine 2D-Matrix aus wellenlängenselektiven Detektoren aufzubauen, wobei lediglich pixelweise variierende Ausleseeigenschaften erzielt werden.

Der Erfindung liegt die Aufgabe zugrunde, eine Vorrichtung zur spektrometrischen Erfassung von Licht anzugeben, die derart geeignet ausgebildet ist, dass die spektrale Aufspaltung des Eingangssignals und die Umwandlung in einen auswertbaren Datenstrom innerhalb einer einstückigen Komponenten-Struktur gleichzeitig stattfinden. Die Verwendung von organischen Halbleitern ermöglicht eine kostengünstige und gut integrierbare Herstellung. Zusätzlich kann durch optische Verstärkungseffekte des Filters die Wechselwirkung des Detektors mit dem zu analysierenden Lichtspektrum erhöht und damit dessen Empfindlichkeit verbessert werden.

Die Aufgabe der Erfindung wird mittels der Merkmale des Patentanspruchs 1 gelöst.

Ein Filter im Sinne der Erfindung bezeichnet ein optisches Bauelement, das spektrale Komponenten des Lichts oder des Lichtsignals räumlich auftrennen kann. Die Wellenlängenauftrennung wird bestimmt durch die Schichtabfolge und die Schichtdicken der einzelnen Schichten.

Erfindungsgemäß bezeichnen organische Photodioden Schichtfolgen aus mindestens einem photoaktiven, organischen Halbleitermaterial, sowie zwei Elektroden zum Abtransport der generierten Ladungsträger und damit der elektrischen Signalerzeugung. Es können weitere Hilfsschichten aus abweichenden Materialien eingesetzt werden, um die Effizienz oder Empfindlichkeit (Intensität oder Spektrum) zu verändern. Dazu zählen Elektronen-/Lochblocker, Transportschichten für Ladungsträger, dotierte Schichten. Über lokale Variation der Schichtzusammensetzung (beispielsweise der Art und Menge der absorbierenden Moleküle) kann eine Anpassung des optimalen Arbeitsspektrums des Detektors an den spektralen Verlauf der Filterstruktur hergestellt werden. Erreicht werden kann dies bspw. durch Off-Axis-Aufdampfverfahren, temporäre Abschattung von einzelnen Gebieten, Druckmethoden oder Schleuder- und Tauchverfahren.

In diesem Fall sorgt die Funktionsweise eines Mikroresonators zu einer erhöhten Wechselwirkung zwischen dem Detektor/der Photodiode und den gefilterten Photonen.

Für resonante Frequenzen/Wellenlängen bilden sich in der Resonanzschicht stehende elektromagnetische Wellen aus, deren Feldamplitude ein Vielfaches des Ausgangswertes der eingestrahlten Welle besitzt. Die Intensität ist proportional zum Quadrat der Amplitude; damit erhöht sich bei einem organischen Detektor mit photoaktivem Material geringen Absorptionskoeffizientens dessen Empfindlichkeit.

In einer Modellbetrachtung eines Mikroresonators durchlaufen Photonen, die sich in der Resonanzschicht befinden, diese Q mal, wobei mit Q die Güte eines Mikroresonators angegeben wird, welche im Wesentlichen durch das Reflexionsvermögen von dessen Spiegeln bestimmt wird. Je größer Q ist (je reflektiver seine Spiegel, Stand der Technik > 1.000 - 10.000), umso öfter durchläuft ein Photon die Resonanzschicht, d.h. effektiv wird die Detektordicke vervielfacht und es erhöht sich drastisch die Wahrscheinlichkeit, dass ein Photon ein elektrisch detektierbares Elektron-Loch-Paar erzeugt.

Der Filter und die nach der Eintrittsfläche des Filters nachgeordnete Photodiode kontaktieren derart miteinander, dass sie die monolithische Einheit bilden, wobei der Filter zumindest aus einem spektral auflösenden Element in Form mindestens eines photonischen Kristalls besteht, bei dem mindestens eine Schicht mit variabler Dicke D entlang einer Richtung senkrecht zum Lichteinfall ausgebildet ist, wobei die mit dem Filter kontaktierende organische Photodiode zumindest aus folgenden Detektorschichten besteht:
der photoaktiven Schicht,
der ersten Elektrode der photoaktiven Schicht und
der zweiten Elektrode der photoaktiven Schicht,
wobei sich die photoaktive Schicht zwischen den beiden Elektroden befindet.

In der photoaktiven Schicht der organischen Photodiode können sich durch Erzeugung mittels Lichteinstrahlung Ladungsträger im gesamten spektral sensitiven Bereich befinden.

Der Filter kann als linearer Verlaufsfilter mit Bragg-Reflektoren ausgebildet sein.

Eine transparente Schicht kann als Substrat zur mechanischen Stabilisierung des Filters an einer der Schichtanordnungen angebracht sein.

Der wellenlängenabhängige Mikroresonator kann somit keilförmig ausgebildet sein.

Eine spektrometrische Einrichtung zur Erfassung von Licht unter Einsatz der vorgenannten Vorrichtung kann zumindest umfassen
- eine Lichtquelle,
- einen Filter zur Umwandlung von spektralen Informationen in Ortsinformationen mit einer Eintrittsfläche, auf die die Lichtanteile seitens der Lichtquelle fallen,
- einen Detektor in Form einer organischen Photodiode zur Erfassung der Ortsinformationen und Umwandlung der Ortsinformationen in weiterleitbare elektrische Signale,
- eine Auswerteeinheit, die über signalführende Verbindungsleitungen mit der organischen Photodiode verbunden ist, und
- eine Anzeigeeinheit,
wobei der Filter und die nach der Eintrittsfläche des Filters nachgeordnete Photodiode durch die erfindungsgemäße Vorrichtung realisiert sind.

Zumindest eine der Elektroden des Detektors ist strukturiert ausgebildet.

Die Verbindungsleitungen zur Signalführung können zwischen dem Detektor und der Auswerteeinheit vorhanden sein.

Es gibt einen durchgelassenen Anteil des aus der Lichtquelle emittierten und einfallenden Lichtes nach dem Durchgang durch den Filter hindurch im transparenten Bereich der Vorrichtung, wobei der Anteil des durchgelassenen Lichtes Ladungsträger im sensitiven Bereich der photoaktiven Schicht erzeugt, die ein optisches Signal ausbilden und in ein weiterleitbares elektrisches Signal umgewandelt werden, und
wobei das jeweils erhaltene elektrische Signal über die Verbindungsleitungen an die Auswerteeinheit zur Auswertung geleitet wird.

Zusammenfassend kann beschrieben werden:
Als spektral auflösendes Element wird ein photonischer Kristall, z. B. ein Mikroresonator, eingesetzt, bei dem mindestens eine Materialschicht mit variabler Dicke D entlang einer Richtung senkrecht zum Lichteinfall ausgeführt ist.

Für die Detektion wird eine entlang des spektral auflösenden Elementes ortssensitive Schichtstruktur, z. B. eine organische Photodiode/Solarzelle oder Perowskite, verwendet, in der Photonen in Ladungsträger umwandelt werden. Über deren Elektroden kann anschließend der Ort des Signals und durch eine Kalibrierung die spektrale Information erhalten werden.

Abhängig von der konkreten Schichtstruktur und den verwendeten Materialien ist der Detektor filtereingreifend in dessen Resonanzschicht eingebettet.

Weiterbildungen und vorteilhafte Ausgestaltungen der Erfindung sind in weiteren Unteransprüchen angegeben.

Die Erfindung wird anhand von Ausführungsbeispielen mittels mehrerer Zeichnungen näher erläutert:

Es zeigt:
- Fig. 1: eine schematische Darstellung einer monolithischen Vorrichtung zur Erfassung von Licht, insbesondere von Lichtimpulsen, nach Stand der Technik wobei
Fig. 1a eine zweite monolithische Vorrichtung nach Stand der Technik, Fig. 1b eine dritte monolithische erfindungsgemäße Vorrichtung und Fig. 1c eine vierte monolithische Vorrichtung nach Stand der Technik zeigt,
- Fig. 2: eine schematische Darstellung einer spektrometrischen Einrichtung zur Erfassung von Licht, insbesondere von Lichtimpulsen mit der monolithischen Vorrichtung nach Fig. 1b,

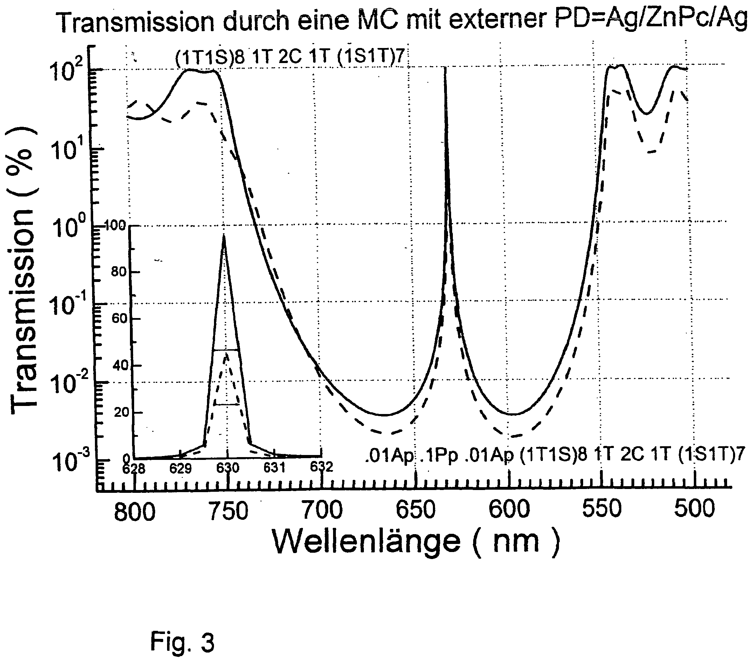

- Fig. 3: eine Darstellung der Transmission der Struktur Photodiode und Mikrokavität (1T1S)8 1T 2mC 1T (1S1T) 7 in Abhängigkeit der Wellenlänge mit einem Vergleich der Transmissionseigenschaften einer einzelnen Mikrokavität mit der jeweiligen Schichtzusammensetzung, beinhaltend zwei dielektrische Spiegelschichten (1T1S)8 1T sowie 1T(1S1T)7 und den verschiedenen Strukturen, wobei 2C niedrigbrechendes Material mit einer optischen Dicke von λ/2 und 4C niedrigbrechendes Material mit einer Dicke λ darstellen sowie 10/100 Ap 100/125Zp 10/20 Ap geführt zu 10/100nm Ag (Silber), 100/125nm Photodiode (ZnPc - Zinkphthalozyanin als repräsentative absorptive Schicht), 10/20nm Ag (Silber) hinter der Mikrokavität,
- Fig. 4: eine Darstellung der Feldamplitude ohne/mit Metallschicht (z. B. Ag) im Inneren der Resonanzschicht eines Mikroresonators, wobei trotz des geringen Transmissionsgrades von 20 nm Silber sich durch die Anordnung in einem Feldknoten die Erhöhung der Feldamplitude nur vom Faktor 25 auf den Faktor 15 reduziert,
- Fig. 5: eine Darstellung eines Feldamplitudenverlaufs bei einer Anordnung einer Modell-Photodiode (10nm Ag, 150nm ZnPc, 20nm Ag) hinter einer Mikrokavität (Resonanzschicht eines Filters), wobei trotz des absorptiven Charakters der Photodiode die maximale Feldamplitude des Mikroresonators einer Verstärkung von "18" entspricht,
- Fig. 6: eine Darstellung des Intensitätsverlaufes des elektrischen Feldes für die Photodiode nachgeordnet der Mikrokavität gemäß Fig. 5, aufgetragen über Wellenlängen sowie die Dicke der organischen Schicht, und
- Fig. 7: eine schematische Darstellung einer spektrometrischen Einrichtung zur Erfassung von Licht mit einer Vorrichtung nach dem Stand der Technik.

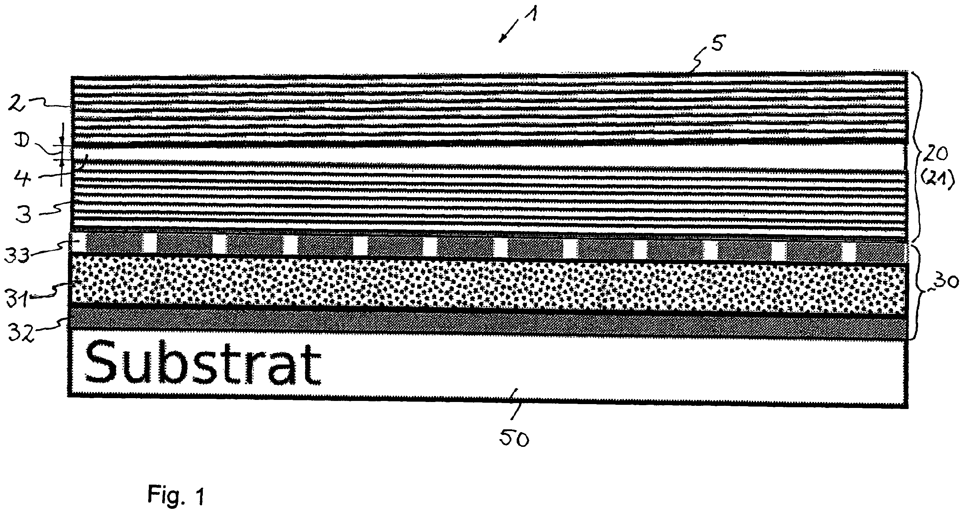

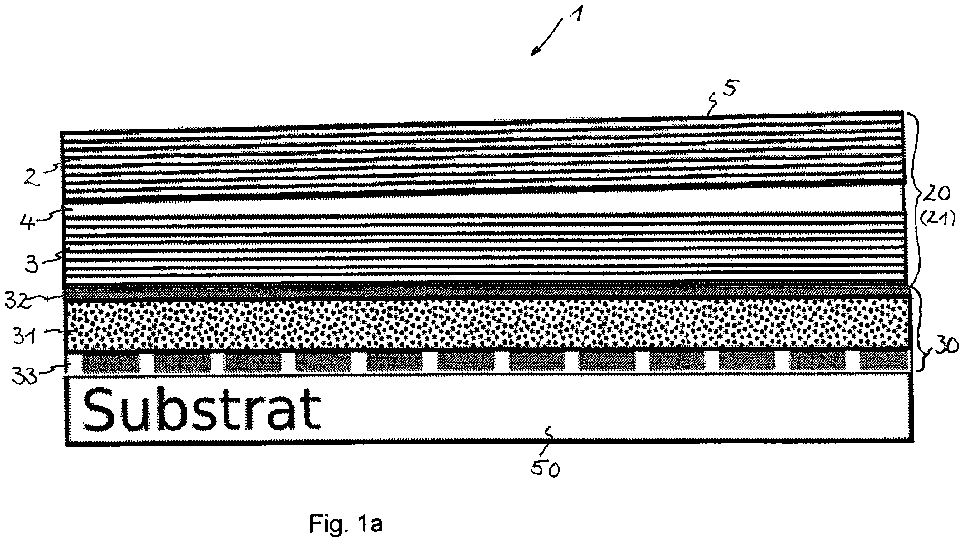

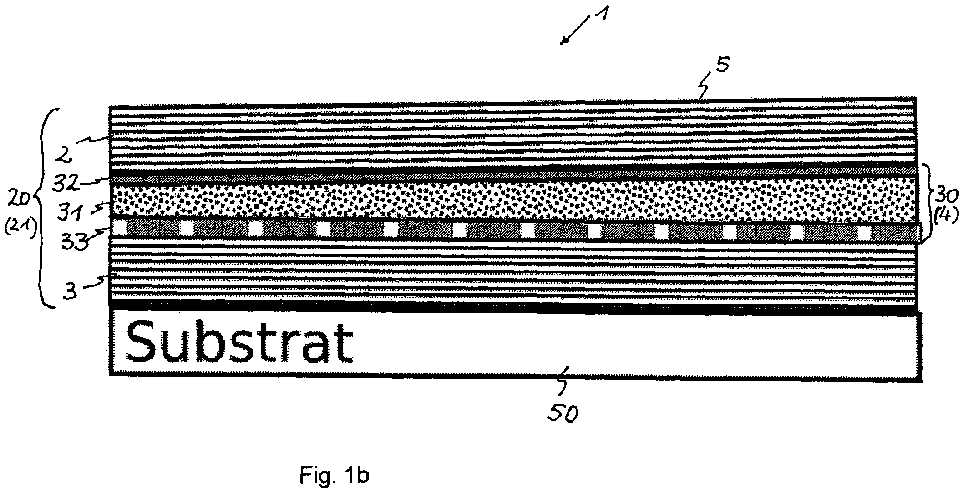

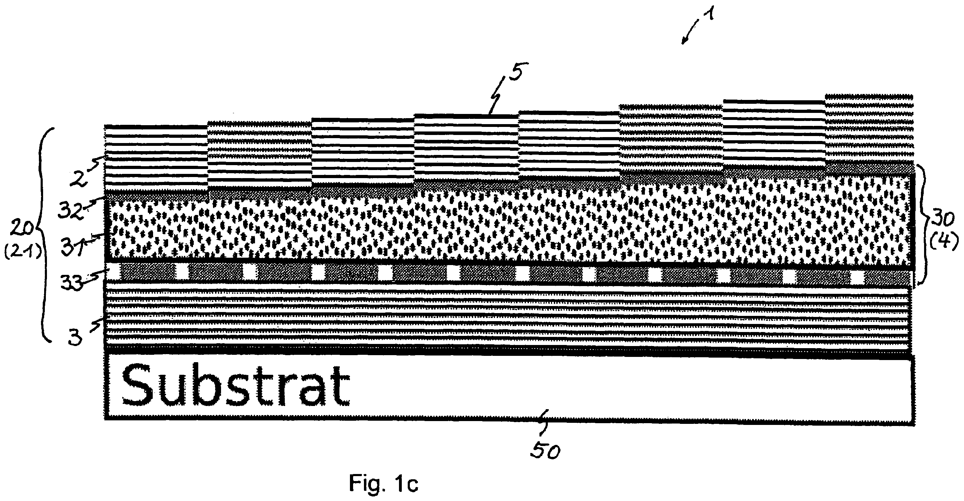

In Fig. 1 ist eine Vorrichtung 1 zur spektrometrischen Erfassung von Licht, insbesondere von Lichtimpulsen, nach Stand der Technik dargestellt,
wobei die Vorrichtung 1 zumindest umfasst
- einen Filter 20 zur Umwandlung von spektralen Informationen in Ortsinformationen und
- eine organische Photodiode 30 zur Umwandlung der Ortsinformationen in weiterleitbare elektrische Signale.

Der Filter 20 und die organische Photodiode 30 bilden einen einstückigen Monolithen, wobei die organische Photodiode 30 in einer Anbindungsanordnung an den Filter 20 zusammengeführt ist.

Der Filter 20 und die nach der Eintrittsfläche 5 des Filters 20 nachgeordnete Photodiode 30 kontaktieren derart miteinander, dass sie die monolithische Einheit bilden,
wobei der Filter 20 im Detail zumindest
aus einem spektral auflösenden Element in Form mindestens eines photonischen Kristalls 21 besteht, bei dem mindestens eine Schicht 2, 3, 4 mit variabler wellenlängenabgestimmter Dicke D entlang einer Richtung senkrecht zum Lichteinfall ausgebildet ist,
wobei die mit dem Filter 20 kontaktierende organische Photodiode 30 zumindest aus folgenden Detektorschichten besteht:
   - einer photoaktiven Schicht 31 zur Ladungsträgererzeugung,
   - einer ersten Elektrode 33 der photoaktiven Schicht 31 und
   - einer zweiten Elektrode 32 der photoaktiven Schicht 31,
wobei die photoaktive Schicht 31 sich zwischen den beiden Elektroden 33, 32 befindet und eine der beiden Elektroden, die erste Elektrode 33, mit dem photonischen Kristall 21 in engem Kontakt steht.

Die andere zweite Elektrode 32 der photoaktiven Schicht 31 kann mit einem beiderseitig ebenen, als Schicht ausgebildeten Substrat 50 in Verbindung stehen.

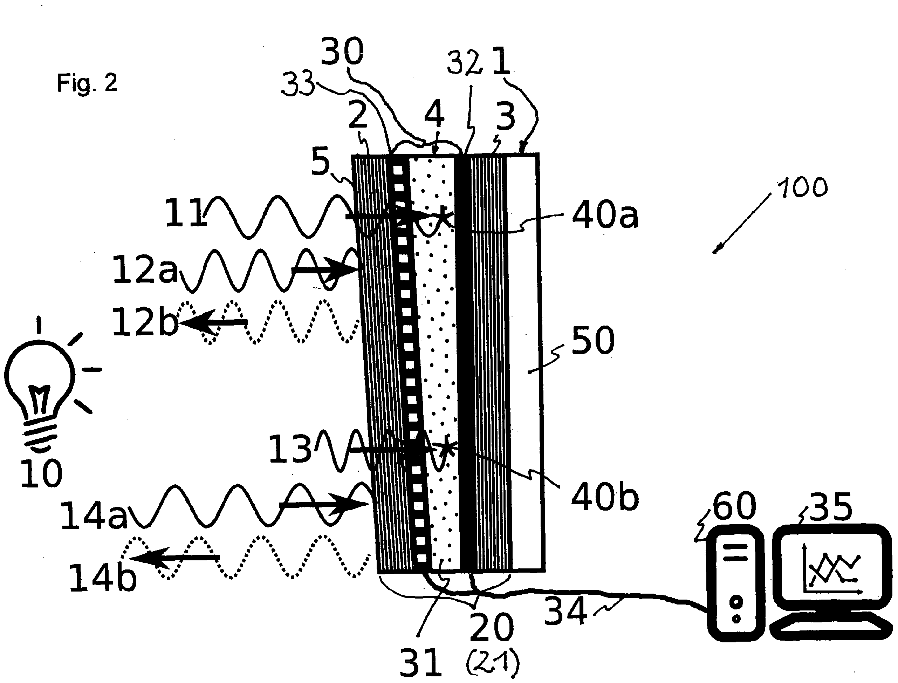

Erfindungsgemäß befinden sich gemäß der Fig. 1b, Fig. 1c und Fig. 2 die Detektorschichten 33, 32, 31 der Photodiode 30:
- die photoaktive Schicht 31 zur Ladungsträgererzeugung,
- die erste Elektrode 33 der photoaktiven Schicht 31 und
- die zweite Elektrode 32 der photoaktiven Schicht 31
in Integration innerhalb der Resonanzschicht 4 des photonischen Kristalls 21 und zwischen den sich gegenüberliegenden Schichtanordnungen 2 und 3.

Die Detektorschichten 33, 32, 31 sind in den Filter 20 integriert und bilden mit dem umgebenden Filter 20 die monolithische Einheit.

In der photoaktiven Schicht 31 der organischen Photodiode 30 insbesondere im sensitiven Bereich der Vorrichtung 1 können sich gemäß Fig. 2 durch Erzeugung mittels einfallenden Lichtes 11 bzw. 13 Ladungsträger 40a im langwellig sensitiven Bereich und Ladungsträger 40b im kurzwellig sensitiven Bereich der Photodiode 30 befinden.

Da sich durch die Regelmäßigkeit/Periodizität eine Analogie zur Behandlung von Kristallstrukturen in der Festkörpertheorie ergibt, werden photonische Strukturen auch als photonische Kristalle bezeichnet.

Dabei kennzeichnet die Dimensionalität die Anzahl an Raumrichtungen, die photonisch wirksame Variationen besitzen, d.h. ein eindimensionaler photonischer Kristall ist nur in einer Raumrichtung (z. B. nach oben) mit einer Brechungsindexänderung versehen, während die beiden anderen Raumrichtungen (in der Ebene) keine Variation aufweisen.

Der Filter 20 kann als linearer Verlaufsfilter mit Bragg-Reflektoren ausgebildet sein.

Der Filter 20 kann als Mikroresonator ausgebildet sein, wobei der Mikroresonator als eine dielektrische Spiegelanordnung ausgebildet ist, der zumindest besteht aus
einer ersten Spiegelschichtanordnung 2 mit abwechselnd hochbrechenden und niedrigbrechenden Materialschichten,
einer zweiten Spiegelschichtanordnung 3 mit abwechselnd hochbrechenden und niedrigbrechenden Materialschichten,
einer Resonanzschicht 4, die zwischen der ersten Spiegelschichtanordnung 2 und der zweiten Spiegelschichtanordnung 3 angeordnet ist, und einer transparenten Schicht 50 als stabilisierendes Element,
wobei mindestens eine der beiden Spiegelschichtanordnungen 2, 3 oder zumindest die Resonanzschicht 4 mit variabler stetig ansteigender Dicke D entlang der Richtung senkrecht zum Lichteinfall ausgebildet ist.

Der in Fig. 1 dargestellte Filter 20 kann aber auch als Mikroresonator 21 ausgebildet sein, wobei der Mikroresonator 21 zumindest besteht aus:
einem ersten Schichtstapel 2 mit einem ersten vorgegebenen Brechungsindex, einem zweiten Schichtstapel 3 mit einem zweiten vorgegebenen Brechungsindex, wobei sich der erste Brechungsindex und der zweite Brechungsindex voneinander unterscheiden, und
einer Resonanzschicht 4, die zwischen den beiden Schichtstapeln 2, 3 angeordnet ist,
wobei mindestens eine der beiden Schichtstapel 2, 3 oder zumindest die Resonanzschicht 4 mit variabler stetig ansteigender Dicke D entlang der Richtung senkrecht zum Lichteinfall ausgebildet ist.

Eine transparente Schicht kann als Substrat 50 zur mechanischen Stabilisierung des Filters 20 an einer der Schichtanordnungen 2 oder 3 angebracht sein.

Der Mikroresonator 21 kann damit z. B. keilförmig ausgebildet sein.

In Fig. 1a ist eine zweite monolithische Vorrichtung 1 nach Stand der Technik in Form eines keilförmigen Mikroresonators mit einer Vertauschung der vorhandenen Elektroden 32, 33 bei stetig ansteigender (divergenter) Dicke gemäß Fig. 1 dargestellt.

In Fig. 1b ist eine erfindungsgemäße monolithische Vorrichtung 1 ebenfalls in Form eines keilförmigen Mikroresonators mit einer eine variable stetig ansteigende (divergente) Dicke aufweisenden Resonanzschicht, wobei die Resonanzschicht 4 aus Fig. 1 in Fig. 1b durch den integrierten Detektor 30 ersetzt und mit stetig ansteigender (divergenter) Dicke zwischen den Schichten 2 und 3 integriert angeordnet ist, gezeigt.

In Fig. 1c ist eine weitere monolithische Vorrichtung 1 nach Stand der Technik in Form eines Mikroresonators mit abschnittsweise stufenförmig divergent ausgebildeten Detektor 30 anstelle der inneren Resonanzschicht 4 ausgeführt, wobei die obere Schicht 2 zwar in ihren Abschnitten eine konstante Dicke aufweist, aber durch den stufenförmig ausgebildeten Detektor 30 die Stufenausbildung des Detektors 30 übernimmt, und die untere Schicht 3 als beiderseitig ebene, an dem Substrat 50 anliegende Schicht ausgeführt ist.

Die Resonanzschicht 4 des Mikroresonators 21 wird auch als Mikrokavität (MC) bezeichnet.

In Fig. 3 ist eine Darstellung der Transmission der Struktur (1T1S) 81T 2mC 1T (1S1T) 7 mit einem Vergleich der Transmissionseigenschaften einer Mikrokavität (MC) mit der jeweiligen Schichtzusammensetzung gezeigt, beinhaltend zwei dielektrische Spiegelschichten (1T1S) 8 1T sowie 1T(1S1T)7 und den verschiedenen Strukturen, wobei 2C niedrigbrechendes Material mit λ/2 und 4C niedrigbrechendes Material mit λ darstellen sowie 10 Ap 100Zp 10 Ap geführt zu 10nm Ag, 100nm Photodiode 30 (ZnPc - Zinkphthalozyanin als repräsentative absorptive Schicht), 10nm Ag hinter der Mikrokavität (MC).

Dabei bedeuten
1T einer λ/4 dicken Schicht Titandioxid,
2T einer λ/2 dicken Schicht Titandioxid,
1S einer λ/4 dicken Schicht Siliziumdioxid,
2S einer λ/2 dicken Schicht Siliziumdioxid,
(1T1S)7 einem dielektrischen Spiegel aus sieben Titandioxid/Siliziumdioxid-Schichtpaaren,
(1T1S)8 einem dielektrischen Spiegel aus acht Titandioxid/Siliziumdioxid-Schichtpaaren,
2mC m Vielfachen einer λ/2-Schicht niedrigbrechenden Materials (n = 1.5).

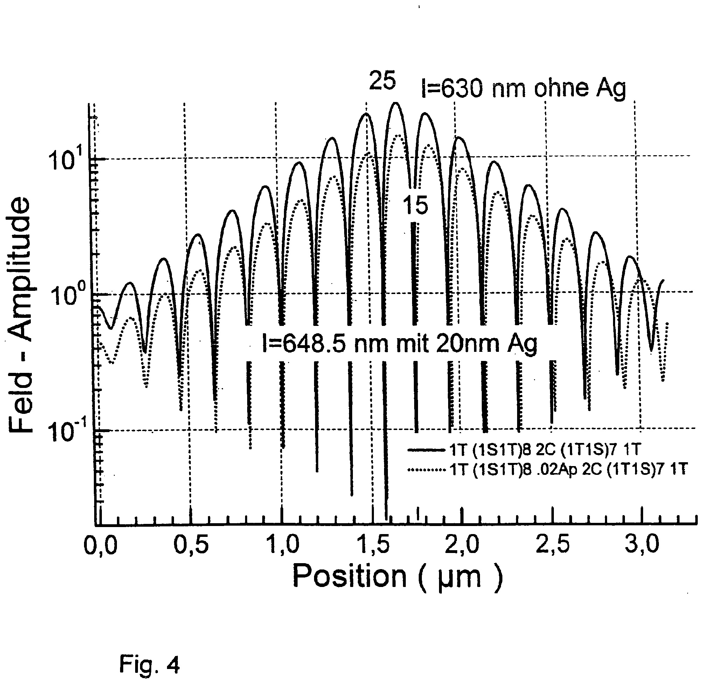

In Fig. 4 ist eine Darstellung der Feldamplitude ohne/mit Silberschicht am Rand der Resonanzschicht 4 eines Mikroresonators 21 gezeigt, wobei trotz des geringen Transmissionsgrades von 20 nm Silber sich durch die Anordnung in einem Feldknoten die Erhöhung der Feldamplitude nur vom Faktor 25 auf den Faktor 15 reduziert.

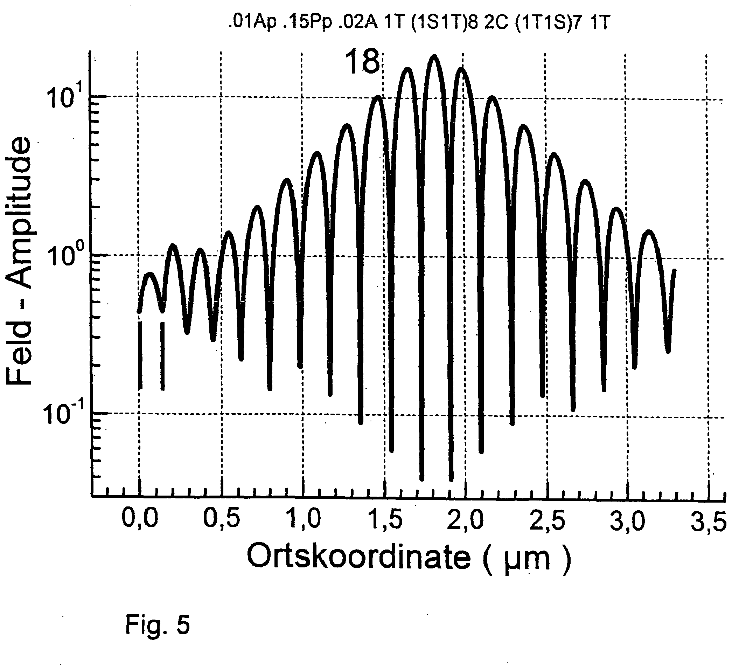

In Fig. 5 ist eine Darstellung eines Feldamplitudenverlaufs bei einer Anordnung einer Modell-Photodiode (10nm Ag, 150nm ZnPc, 20nm Ag) hinter einer Mikrokavität gezeigt, wobei trotz des absorptiven Charakters der Photodiode die maximale Feldamplitude des Mikroresonators einer Verstärkung mit dem Faktor "18" entspricht.

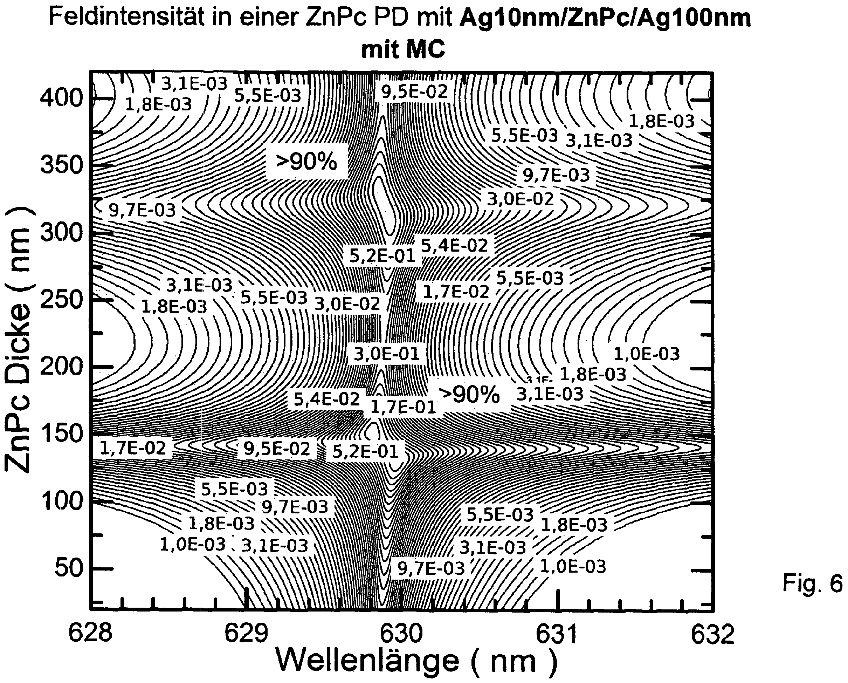

In Fig. 6 ist eine Darstellung des Intensitätsverlaufes des elektrischen Feldes für die Photodiode aus der Fig. 5 gezeigt, aufgetragen über Wellenlängen nahe der Resonanzfrequenz der Photodioden-Struktur.

Die Schicht aus ZnPc - Zinkphthalozyanin (ZnPc) stellt die photoaktive Schicht 31 der Photodiode 30 dar.

Die in Fig. 2 dargestellte spektrometrische Einrichtung 100 - Spektrometer - umfasst unter Einsatz der vorgenannten Vorrichtung 1 aus Fig. 1b
zumindest
eine Lichtquelle 10,
einen Filter 20 zur Umwandlung von spektralen Informationen in Ortsinformationen mit einer Eintrittsfläche 5, auf die die Lichtanteile 11, 12a, 13, 14a seitens der Lichtquelle 10 fallen,
einen Detektor 30 in Form einer organischen Photodiode zur Umwandlung der Ortsinformationen in weiterleitbare elektrische Signale,
eine Auswerteeinheit 60, die über die elektrische Signale leitende Verbindungsleitungen 34 mit der Photodiode 30 verbunden ist, und eine Anzeigeeinheit 35.

Dabei kontaktieren der Filter 20 und die hinter der Eintrittsfläche 5 des Filters 20 nachgeordnete Photodiode 30 derart miteinander, dass beide Komponenten 20 und 30 die erfindungsgemäße einstückige monolithische Einheit bilden,
wobei der Filter 20 zumindest
aus einem spektral auflösendem Element in Form mindestens eines photonischen Kristalls 21 besteht, bei dem mindestens eine Schicht 2, 3, 4 mit stetig variabler Dicke D entlang einer Richtung senkrecht zum Lichteinfall ausgebildet ist (in Fig. 2 Schicht 4 mit stetig variabler Dicke dargestellt),
wobei der mit dem Filter 20 kontaktierende Detektor 30 zumindest aus folgenden Detektorschichten besteht
einer photoaktiven Schicht 31,
einer ersten Elektrode 33 der photoaktiven Schicht 31 und einer zweiten Elektrode 32 der photoaktiven Schicht 31,
wobei die photoaktive Schicht 31 sich zwischen den beiden Elektroden 33, 32 befindet, und
die Detektorschichten 31, 32, 33 sich innerhalb der Resonanzschicht 4 des photonischen Kristalls 21 des Filters 20 befinden oder die Detektorschichten 31, 32, 33 gleichzeitig auch als Resonanzschicht 4 ausgebildet sind und als solche wirken.

Zumindest eine der Elektroden 32, 33 des Detektors 30 ist strukturiert ausgebildet.

Es gibt einen durchgelassenen Anteil 13 des einfallenden Lichtes aus der Lichtquelle 10 nach dem Durchgang durch den Filter 20 hindurch im transparenten Bereich der Vorrichtung 1, wobei der durchgelassene Anteil 13 Ladungsträger 40a und/oder 40b im sensitiven Bereich der photoaktiven Schicht 31 erzeugt, wobei die Ladungsträger 40a und/oder 40b ein registrierbares Signal auslösen,
wobei im Detektor 30 die von den Ladungsträgern 40a und/oder 40b ausgehenden Signale über die Verbindungsleitungen 34 an die Auswerteeinheit 60 zur Auswertung geleitet werden.

Die Lichtquelle 10 emittiert das erforderliche Licht.

In Fig. 2 sind folgende Signal-/Lichtanteile und ihre Funktionen angegeben: Dabei gibt es
einen langwelligen Anteil 11 des Lichtes beim Durchgang des Filters 20 im langwellig spektral sensitiven Bereich,
einen kurzwelligen Anteil 12a des Lichtes vor dem Auftreffen auf den Filter 20 im langwellig transparenten Bereich,
einen kurzwelligen Anteil 12b des Lichtes nach dem Auftreffen auf den Filter 20 im langwellig transparenten Bereich,
einen kurzwelligen Anteil 13 des Lichtes beim Durchgang des Filters 20 im kurzwellig spektral sensitiven Bereich,
einen langwelligen Anteil 14a des Lichtes vor dem Auftreffen auf den Filter 20 im kurzwellig transparenten Bereich und
einen langwelligen Anteil 14b des Lichtes nach dem Auftreffen auf den Filter 20 im kurzwellig transparenten Bereich.

Die genannten Bereiche stellen Wellenlängenbereiche dar.

Die Vorteile des erfindungsgemäßen monolithischen Vorrichtung 1 gemäß Fig. 1b und der die monolithischen Vorrichtung 1 enthaltenden spektrometrischen Einrichtung 100 bestehen in Folgendem:
Bei der erfindungsgemäßen Vorrichtung 1 gemäß Fig. 1b ist durch die direkte Verbindung des Detektors/der Photodiode 30 und des spektral auflösenden Elements 20 - des Filters - eine Dejustage der wesentlichen Vorrichtungs-Komponenten 30, 20 ausgeschlossen. Des Weiteren entfällt eine spektrale Kalibrierung der Vorrichtung 1. Die vorteilhaft geringe Ausdehnung sowie die einfache Möglichkeit einer Kapselung der Photodiode 30 an/in den Filter 20 erlauben den Einsatz in beengten und beanspruchten Umgebungen.
Die Struktur der erfindungsgemäßen monolithischen Vorrichtung 1 aus Filter 20 und Detektor 30 lässt sich als komplette Einheit in einem Prozess herstellen (z. B. PVD-Verfahren für Filter- und Detektorschichten), wodurch ein sehr kostengünstiger Sensor entsteht.
Die Wahl von (teil-)transparenten Materialien für Filter 20 und Detektor 30 sowie Substrat 50 ermöglicht einen parallelen Durchgang des Lichtes bei gleichzeitiger Analyse des Spektrums.
Werden die Detektorschichten 33, 32, 31 in den Filter 20 integriert, kann bei geringem Materialeinsatz der photoaktiven Materialien in der photoaktiven Schicht 31 eine verbesserte Sensitivität erreicht werden (Feldverstärkung in Mikroresonatoren und eine hohe Anzahl von Umläufen resonanter Photonen).

### Bezugszeichenliste

- 1: Vorrichtung
- 2: erste Materialschicht mit vorgegebenem Brechungsindex
- 3: zweite Materialschicht mit unterschiedlich vorgegebenem Brechungsindex
- 4: Resonanzschicht
- 5: Eintrittsfläche des Filters
- 10: Lichtquelle
- 11: langwelliger Anteil des Lichtes beim Durchgang des Filters im langwellig spektral sensitiven Bereich
- 12a: kurzwelliger Anteil des Lichtes vor dem Auftreffen auf den Filter im langwellig transparenten Bereich
- 12b: kurzwelliger Anteil des Lichtes nach dem Auftreffen auf den Filter im langwellig transparenten Bereich
- 13: kurzwelliger Anteil des Lichtes beim Durchgang des Filters im kurzwellig spektral sensitiven Bereich
- 14a: langwelliger Anteil des Lichtes vor dem Auftreffen auf den Filter im kurzwellig transparenten Bereich
- 14b: langwelliger Anteil des Lichtes nach dem Auftreffen auf den Filter im kurzwellig transparenten Bereich
- 20: Filter
- 21: photonischer Kristall/Mikroresonator
- 30: Detektor/organische Photodiode
- 31: photoaktive Schicht/Detektorschicht
- 32: zweite Elektrode der photoaktiven Schicht/zweite Detektorschicht
- 33: erste Elektrode der photoaktiven Schicht/erste Detektorschicht
- 34: Verbindungsleitung/en
- 35: Anzeigeeinheit
- 40a: Ladungsträger im langwellig sensitiven Bereich der photoaktiven Schicht
- 40b: Ladungsträger im kurzwellig sensitiven Bereich der photoaktiven Schicht
- 50: Substrat
- 60: Auswerteeinheit
- 100: spektrometrische Einrichtung gemäß Erfindung
- 101: Vorrichtung nach dem Stand der Technik
- 102: spektrometrische Einrichtung nach dem Stand der Technik

- Ag: Silber
- ZnPc: Zinkphthalozyanin
- MC: Mikrokavität
- PD: Photodiode
- T: Titandioxid
- S: Siliziumdioxid
- C: niedrigbrechendes Material (n = 1.5)
- D: Dicke

## Patentansprüche

1. Vorrichtung (1) zur spektrometrischen Erfassung von Licht, zumindest umfassend
- einen Filter (20) zur Umwandlung von spektralen Informationen in Ortsinformationen, wobei der Filter ein optisches Bauelement ist, das spektrale Komponenten des Lichts räumlich auftrennen kann, und
- eine organische Photodiode (30) als Detektor zur Umwandlung der Ortsinformationen in weiterleitbare elektrische Signale,
wobei der Filter (20) und die organische Photodiode (30) einen einstückigen Monolithen bilden, wobei die organische Photodiode (30) in einer Integration mit dem Filter (20) zusammengeführt ist,
wobei der Filter (20) zumindest
aus einem spektral auflösenden Element in Form mindestens eines den Monolithen darstellenden, schichtartigen photonischen Kristalls (21) besteht, wobei der Filter (20) als wellenlängenabhängiger Mikroresonator (21) ausgebildet ist, wobei der Mikroresonator (21) als eine dielektrische Spiegelanordnung ausgebildet ist, zumindest bestehend aus
- einer ersten Spiegelschichtanordnung (2) mit abwechselnd hochbrechenden und niedrigbrechenden Materialschichten,
- einer zweiten Spiegelschichtanordnung (3) mit abwechselnd hochbrechenden und niedrigbrechenden Materialschichten und
- einer Resonanzschicht (4), die sich zwischen den beiden Spiegelschichtanordnungen (2, 3) befindet, oder
wobei der Mikroresonator (21) zumindest besteht aus:
- einem ersten Schichtstapel (2) mit einem ersten vorgegebenen Brechungsindex,
- einem zweiten Schichtstapel (3) mit einem zweiten vorgegebenen Brechungsindex, wobei sich der erste Brechungsindex und der zweite Brechungsindex voneinander unterscheiden, und
- einer Resonanzschicht (4), die zwischen den beiden Schichtstapeln (2, 3) angeordnet ist,
wobei mindestens eine Schicht (2, 3, 4) mit wellenlängenabgestimmter,
stetig ansteigender Dicke D entlang einer Richtung senkrecht zu einer Richtung, entlang der die Schichten des Filters übereinander angeordnet sind, ausgebildet ist,
wobei die mit dem Filter (20) kontaktierende organische Photodiode (30) zumindest aus folgenden Detektorschichten besteht:
- einer photoaktiven Schicht (31),
- einer ersten Elektrode (33) der photoaktiven Schicht (31) und
- einer zweiten Elektrode (32) der photoaktiven Schicht (31),
wobei die photoaktive Schicht (31) sich zwischen den beiden Elektroden (33, 32) befindet und mindestens eine der Elektroden (33, 32) strukturiert entlang der Richtung, in der die Dicke D stetig ansteigt, ausgebildet ist, **dadurch gekennzeichnet,**
**dass** sich die Detektorschichten (33, 32, 31):
- die photoaktive Schicht (31),
- die erste Elektrode (33) der photoaktiven Schicht (31) und
- die zweite Elektrode (32) der photoaktiven Schicht (31),
innerhalb der Resonanzschicht (4) des photonischen Kristalls (21) des Filters (20) befinden.

2. Vorrichtung nach den Anspruch 1, **dadurch gekennzeichnet, dass** sich in der photoaktiven Schicht (31) der organischen Photodiode (30) durch Erzeugung mittels Lichteinstrahlung Ladungsträger (40a) im langwellig sensitiven Bereich und/oder Ladungsträger (40b) im kurzwellig sensitiven Bereich befinden.

3. Vorrichtung nach Anspruch 1 oder 2, **dadurch gekennzeichnet, dass** der Filter (20) als linearer Verlaufsfilter mit Bragg-Reflektoren ausgebildet ist.

4. Vorrichtung nach einem der Ansprüche 1 bis 3, **dadurch gekennzeichnet, dass** eine transparente Schicht als Substrat (50) zur mechanischen Stabilisierung des Filters (20) an einer der Schichtanordnungen (2; 3) angebracht ist.

5. Vorrichtung nach einem der Ansprüche 1 bis 3, **dadurch gekennzeichnet, dass** der wellenlängenabhängige Mikroresonator (21) keilförmig ausgebildet ist.

6. Spektrometrische Einrichtung (100) zur spektrometrischen Erfassung von Licht unter Einsatz einer Vorrichtung (1) nach einem der Ansprüche 1 bis 5, zumindest umfassend
- eine Lichtquelle (10),
- einen Filter (20) zur Umwandlung von spektralen Informationen in Ortsinformationen mit einer Eintrittsfläche (5), auf die die Lichtanteile (11, 12a, 13, 14a) seitens der Lichtquelle (10) fallen,
- einen Detektor in Form einer Photodiode (30) zur Umwandlung der Ortsinformationen in weiterleitbare elektrische Signale,
- eine Auswerteeinheit (60), die über elektrische Signal führende Verbindungsleitungen (34) mit der Photodiode (30) verbunden ist, und
- eine Anzeigeeinheit (35),
**dadurch gekennzeichnet,**
**dass** der Filter (20) und die organische Photodiode (30) durch eine Vorrichtung (1) nach einem der Ansprüche 1 bis 5 realisiert sind.

7. Einrichtung nach Anspruch 6, **dadurch gekennzeichnet, dass** Verbindungsleitungen (34) zwischen der Photodiode (30) und der Auswerteeinheit (60) vorhanden sind.

8. Einrichtung nach einem der Ansprüche 6 oder 7, **dadurch gekennzeichnet, dass** es einen durchgelassenen Anteil (13) des Lichtes aus der Lichtquelle (10) nach dem Durchgang durch den Filter (20) hindurch im transparenten Bereich der Vorrichtung (1) gibt, wobei der durchgelassene Anteil (13) des Lichtes Ladungsträger (40a, 40b) im sensitiven Bereich der photoaktiven Schicht (31) erzeugt, und
wobei das jeweils erfasste Signal über die elektrische Signale leitenden Verbindungsleitungen (34) an die Auswerteeinheit (60) zur Auswertung geleitet wird.

## Claims

1. Device (1) for spectrometrically capturing light, comprising at least:
- a filter (20) for converting spectral information into spatial information, the filter being an optical component which can spatially separate spectral components of the light, and
- an organic photodiode (30) serving as a detector for converting the spatial information into transmittable electrical signals,
wherein the filter (20) and the organic photodiode (30) form a single-piece monolith, the organic photodiode (30) being integrally combined with the filter (20),
wherein the filter (20) comprises at least one spectrally resolving element in the form of at least one layer-like photonic crystal (21) constituting the monolith,
the filter (20) being designed as a wavelength-dependent microresonator (21), the microresonator (21) being designed as a dielectric mirror arrangement, at least consisting of
- a first mirror layer arrangement (2) with alternating high refractive index and low refractive index material layers,
- a second mirror layer arrangement (3) with alternating high refractive index and low refractive index material layers, and
- a resonant layer (4) located between the two mirror layer arrangements (2, 3),
or
wherein the microresonator (21) consists of at least:
- a first layer stack (2) having a first predetermined refractive index,
- a second layer stack (3) having a second predetermined refractive index, the first refractive index and the second refractive index being different from each other, and
- a resonant layer (4) disposed between the two layer stacks (2, 3),
wherein at least one layer (2, 3, 4) with wavelength-tuned, continuously increasing thickness D along a direction perpendicular to a direction along which the layers of the filter are stacked is formed, wherein the organic photodiode (30) contacting the filter (20) consists of at least the following detector layers
- a photoactive layer (31),
- a first electrode (33) of the photoactive layer (31) and
- a second electrode (32) of the photoactive layer (31),
wherein the photoactive layer (31) is located between the two electrodes (33, 32) and at least one of the electrodes (33, 32) is structured along the direction in which the thickness D continuously increases,
**characterised in that** the detector layers (33, 32, 31):
- the photoactive layer (31),
- the first electrode (33) of the photoactive layer (31), and
- the second electrode (32) of the photoactive layer (31),
are located within the resonant layer (4) of the photonic crystal (21) of the filter (20).

2. Device according to claim 1, **characterised in that** charge carriers (40a) in the long-wavelength sensitive region and/or charge carriers (40b) in the short-wavelength sensitive region are present in the photoactive layer (31) of the organic photodiode (30) by generation by means of light irradiation.

3. Device according to claim 1 or 2, **characterised in that** the filter (20) is designed as a linear graduated filter with Bragg reflectors.

4. Device according to any one of claims 1 to 3, **characterised in that** a transparent layer as substrate (50) for mechanical stabilization of the filter (20) is attached to one of the layer arrangements (2; 3).

5. Device according to any one of claims 1 to 3, **characterised in that** the wavelength-dependent microresonator (21) is wedge-shaped.

6. A spectrometric apparatus (100) for spectrometrically capturing light at least comprising
- a light source (10),
- a filter (20) for converting spectral information into spatial information having an entry surface (5), on which light components (11, 12a, 13, 14) from the light source (10) are incident,
- a detector in the form of an organic photodiode (30) for converting the spatial information into transmittable electrical signals,
- an evaluation unit (60), which is connected to the photodiode (30) via electrical signal-carrying connecting lines (34), and
- a display unit (35),
**characterised in that**
the filter (20) and the organic photodiode (30) are represented by a device (1) according to any one of claims 1 to 5.

7. Apparatus according to claim 6, **characterised in that** connecting lines (34) are provided between the photodiode (30) and the evaluation unit (60).

8. Apparatus according to claim 6 or 7, **characterised in that** after its passage through the filter (20), there is a transmitted component (13) of the light from the light source (10) in the transparent region of the device (1), wherein the transmitted component (13) of the light generates charge carriers (40a, 40b) in the sensitive region of the photoactive layer (31), and wherein the electrical signal obtained is passed via the connecting lines (34) to the evaluation unit (60) for evaluation.

## Revendications

1. Dispositif (1) de capture spectrométrique de la lumière, comprenant au moins :
- un filtre (20) pour convertir des informations spectrales en informations spatiales, le filtre étant un composant optique qui peut séparer spatialement des composantes spectrales de la lumière, et
- une photodiode organique (30) servant de détecteur pour convertir les informations spatiales en signaux électriques transmissibles,
dans lequel le filtre (20) et la photodiode organique (30) forment un monolithe d'une seule pièce, la photodiode organique (30) étant intégralement combinée avec le filtre (20),
dans lequel le filtre (20) comprend au moins un élément à résolution spectrale sous la forme d'au moins un cristal photonique en couche (21) constituant le monolithe,
le filtre (20) étant conçu comme un microrésonateur (21) dépendant de la longueur d'onde, le microrésonateur (21) étant conçu comme un agencement de miroirs diélectriques, constitué au moins de
- d'un premier agencement de couches de miroir (2) avec des couches de matériau à haut indice de réfraction et à faible indice de réfraction alternées,
- un deuxième agencement de couches miroir (3) avec des couches de matériau à haut indice de réfraction et à faible indice de réfraction alternées, et
- une couche résonante (4) située entre les deux agencements de couches miroir (2, 3),
ou
dans lequel le microrésonateur (21) consiste en au moins :
- un premier empilement de couches (2) ayant un premier indice de réfraction prédéterminé,
- un deuxième empilement de couches (3) ayant un deuxième indice de réfraction prédéterminé, le premier indice de réfraction et le deuxième indice de réfraction étant différents l'un de l'autre, et
- une couche résonante (4) disposée entre les deux empilements de couches (2, 3), dans lequel au moins une couche (2, 3, 4) avec une épaisseur D continuellement croissante, accordée en longueur d'onde, le long d'une direction perpendiculaire à une direction le long de laquelle les couches du filtre sont empilées est formée, dans lequel la photodiode organique (30) en contact avec le filtre (20) se compose d'au moins les couches de détecteur suivantes
- une couche photoactive (31),
- une première électrode (33) de la couche photoactive (31) et
- une seconde électrode (32) de la couche photoactive (31),
dans lequel la couche photoactive (31) est située entre les deux électrodes (33, 32) et au moins l'une des électrodes (33, 32) est structurée le long de la direction dans laquelle l'épaisseur D augmente de manière continue,
**caractérisé en ce que** les couches de détection (33, 32, 31) :
- la couche photoactive (31),
- la première électrode (33) de la couche photoactive (31), et
- la deuxième électrode (32) de la couche photoactive (31),
sont situées à l'intérieur de la couche résonante (4) du cristal photonique (21) du filtre (20).

2. Dispositif selon la revendication 1, **caractérisé en ce que** des porteurs de charge (40a) dans la région sensible aux grandes longueurs d'onde et/ou des porteurs de charge (40b) dans la région sensible aux courtes longueurs d'onde sont présents dans la couche photoactive (31) de la photodiode organique (30) par génération au moyen d'une irradiation lumineuse.

3. Dispositif selon la revendication 1 ou 2, **caractérisé en ce que** le filtre (20) est conçu comme un filtre linéaire gradué avec des réflecteurs de Bragg.

4. Dispositif selon l'une quelconque des revendications 1 à 3, **caractérisé en ce qu'**une couche transparente servant de substrat (50) pour la stabilisation mécanique du filtre (20) est fixée à l'un des agencements de couches (2 ; 3).

5. Dispositif selon l'une quelconque des revendications 1 à 3, **caractérisé en ce que** le microrésonateur (21) dépendant de la longueur d'onde est cunéiforme.

6. Appareil spectrométrique (100) pour la capture spectrométrique de la lumière comprenant au moins
- une source de lumière (10),
- un filtre (20) pour convertir des informations spectrales en informations spatiales ayant une surface d'entrée (5), sur laquelle des composants lumineux (11, 12a, 13, 14) provenant de la source lumineuse (10) sont incidents,
- un détecteur sous la forme d'une photodiode organique (30) pour convertir les informations spatiales en signaux électriques transmissibles,
- une unité d'évaluation (60), qui est reliée à la photodiode (30) par des lignes de liaison (34) conductrices de signaux électriques, et
- une unité d'affichage (35),
**caractérisé en ce que**
le filtre (20) et la photodiode organique (30) sont représentés par un dispositif (1) selon l'une quelconque des revendications 1 à 5.

7. Appareil selon la revendication 6, **caractérisé en ce que** des lignes de connexion (34) sont prévues entre la photodiode (30) et l'unité d'évaluation (60).

8. Appareil selon la revendication 6 ou 7, **caractérisé en ce qu'**après son passage à travers le filtre (20), il y a une composante transmise (13) de la lumière de la source lumineuse (10) dans la zone transparente du dispositif (1), dans lequel la composante transmise (13) de la lumière génère des porteurs de charge (40a, 40b) dans la zone sensible de la couche photoactive (31), et
le signal électrique obtenu étant transmis par les lignes de connexion (34) à l'unité d'évaluation (60) pour l'évaluation.
